# EUROPÄISCHE PATENTSCHRIFT

(11) **EP 4 529 405 B1**
(45) Veröffentlichungstag und Bekanntmachung des Hinweises auf die Patenterteilung: **05.08.2026**
(21) Anmeldenummer: 24200777.1
(22) Anmeldetag: 17.09.2024
(51) Int. Cl.: H10N 10/13, H10N 10/17

(54) **VORRICHTUNG ZUR UMWANDLUNG VON WÄRMEENERGIE IN ELEKTRISCHEN STROM**
DEVICE FOR CONVERTING THERMAL ENERGY INTO ELECTRICAL POWER
DISPOSITIF DE CONVERSION D'ÉNERGIE THERMIQUE EN ÉNERGIE ÉLECTRIQUE

(30) Priorität: 21.09.2023 DE 102023125637
(43) Veröffentlichungstag der Anmeldung: 26.03.2025
(73) Patentinhaber: Kriening, Enrico, 04916 Herzberg/Elster (DE)
(72) Erfinder: Kriening, Enrico, 04916 Herzberg/Elster (DE)
(74) Vertreter: Däbritz, Frank

(56) Entgegenhaltungen:
- CN-A- 101 728 987
- CN-A- 116 032 156
- DE-U1- 202009 005 735
- JP-A- 2002 171 776
- JP-A- 2012 222 169
- KR-A- 20180 043 574

## Beschreibung

Die Erfindung betrifft die Umwandlung von Wärmeenergie in elektrischen Strom, wobei ein Temperaturunterschied mittels Peltier-Element in elektrischen Strom gewandelt wird. Peltierelemente sind bekannt. Es sind elektrothermische Wandler, die basierend auf dem Peltier-Effekt bei Stromdurchfluss eine Temperaturdifferenz oder (umgekehrt und für die Erfindung relevant) bei Temperaturdifferenz einen Stromfluss (Seebeck-Effekt) erzeugt.

Peltierelemente werden beispielweise in Camping-Kühlboxen eingesetzt.

DE 20 2009005735 U1 offenbart ein Thermoabsorptionskraftwerk zur Energiegewinnung aus einem Temperaturgefälle und weist zumindest eine Wärme- und zumindest eine Kältezone auf, wobei in der Wärmezone ein Wärmefluid mit einer hohen Temperatur vorgesehen ist und in der Kältezone ein Kältefluid mit einer niedrigen Temperatur strömt. Die Differenz aus der hohen Temperatur des Wärmefluids und der niedrigen Temperatur des Kältefluids bilden das Temperaturgefälle.

Es ist Aufgabe der Erfindung, eine Vorrichtung zur Stromerzeugung bereitzustellen, die nach kurzer Aufheizphase arbeitet. Sie sollte möglichst wenig Aufwand bei der Arbeit erzeugen. Sie sollte darüber hinaus auch die Möglichkeit bieten, mobil eingesetzt zu werden.

Die Aufgabe der Erfindung wird gelöst mit den Merkmalen der unabhängigen Hauptansprüche. Bevorzugte Ausführungsformen werden durch die abhängigen Unteransprüche verdeutlicht. Gegenstand der Erfindung ist eine Vorrichtung zur Umwandlung von Wärmeenergie in elektrischen Strom, umfassend
- mindestens eine durch Wände abgeschlossene Kühlkammer,
- mindestens eine nach außen zu einem Aufheizbereich offene Wärmekammer,
   wobei Wärme- und Kühlkammer mittels einer dieser Wände aneinander angrenzen, so dass
   diese Wand der Kühlkammer auch eine Wand der Wärmekammer bildet, und wobei
   diese Wand ein Peltierelement umfasst, und wobei sich im Aufheizbereich ein Wärmesensor und in den Kühlkammern jeweils ein Kältesensor befindet, und
- Leitungen für ein flüssiges oder gasförmiges Kühlmedium mit einem Zufluss in die Kühlkammern, und
- eine (bevorzugt abnehmbare) Glocke, welche alle Kühlkammern und Wärmekammern umgibt und den (einen gemeinsamen) Aufheizbereich der Vorrichtung von der Außenumgebung abgrenzt,
wobei umfasst sind: · mindestens drei der Kühlkammern, wobei diese jeweils die Form eines dreiseitigen gleichschenkligen Prismas haben und sich einander an ihrer jeweiligen Kante zwischen den gleichen Schenkeln berühren und dort eine Symmetrieachse bilden und wobei sie symmetrisch über die 360° der Symmetrieachse verteilt sind und Zwischenräume bilden, und · mindestens drei der offenen Wärmekammern, welche sich in den Zwischenräumen erstrecken, und wobei diese offenen Wärmekammern ebenfalls dreiseitige gleichschenklige Prismen sind, so dass diese Kühl- und Wärmekammern ein erstes Stockwerk der Vorrichtung bilden, und wobei die Wände an allen drei Seiten der gleichschenkligen Dreiecke Peltierelemente umfassen und auf beiden Wandseiten Kühlrippen aufweisen, und wobei mindestens ein weiteres Stockwerk im gleichen Aufbau, wie das erste Stockwerk, umfasst ist und sich dieses über dem ersten Stockwerk befindet, wobei erstes und jedes weitere Stockwerk zueinander so um die Symmetrieachse versetzt sind, dass jede Kühlkammer von oben durch eine Wärmekammer und umgekehrt begrenzt wird.

Es ist Kern der Erfindung, dass eine Wand, umfassend ein Peltierelement, sowohl eine Kältekammer (Kühlkammer), als auch eine Wärmekammer gegeneinander abgrenzt. Sie ist somit sowohl Wand der Kältekammer, als auch Wand der Wärmekammer. Gemeint sind dabei auch solche Wände, die die Kältekammer zum Aufheizbereich abgrenzen (denn die Wärmekammern sind erfindungsgemäß zum Aufheizbereich offen).

Sinnvollerweise ist die Anzahl an Kühl- und Wärmekammern in der erfindungsgenmäßen Vorrichtung gleich, besonders bevorzugt sind es jeweils 3 oder auch 5 oder das Doppelte, d.h. 6 bzw. 10. Es handelt sich somit immer um Paar aus Kühlkammer und Wärmekammer, wobei die unterschiedlichen Wände unterschiedliche Kühl- und Wärmekammern gegeneinander abgrenzen.

Das Peltierelement ist meist aus Aluminiumoxid-Keramik.

Zur Kühlung:
Jede abgeschlossene Kühlkammer hat mindestens einen Zufluss für das Kühlmedium, um gekühlt zu werden.

Sinnvollerweise gibt es auch einen Abfluss aus der Kühlkammer für das Kühlmedium (zumindest im Falle eines flüssigen Kühlmediums, welches nicht verdampft). Gasförmige Kühlmedien oder flüssige Kühlmedien, welche vollständig verdampfen, wie bspw. flüssiger Stickstoff, können durch Ritzen aus der Kühlkammer entweichen und benötigen keinen Abfluss. Als Kühlmedien kommen bspw. in Frage: Wasser, Kühlspray, gasförmige Kältemittel wie bei Kühlschränken, organische Kühlmedien wie Ethylenglykole und andere.

Bevorzugt grenzt jede Wand der abgeschlossenen Kühlkammern an eine Wärmekammer an bzw. mindestens an den Aufheizbereich (davon ausgenommen sind erkennbar die Wände, die zum Boden reichen. Es ist allerdings auch möglich, die Vorrichtung auf Abstandshalter oder Stelzen zu positionieren, so dass auch unterhalb der Aufheizbereich gebildet wird, der durch die Glocke von der Außenumgebung abgeschirmt wird.

Die "Glocke" im Sinne der Erfindung kann bspw. schwarz oder transparent sein. Sie ist sinnvollerweise abnehmbar, was Vorteile bei der Wartung bietet, kann jedoch auch fest mit dem Boden oder einer Bodenplatte, über denen die Kühl- und Wärmekammern angeordnet sind, verbunden sein.

Sie weist jedenfalls eine gewisse thermische Isolationskraft auf, so dass der Aufheizbereich eine Temperatur sinnvollerweise über Raumtemperatur erreicht. Jedenfalls muss im Sinne der Erfindung die Temperatur im Aufheizbereich (und damit auch in den zum Aufheizbereich offenen Wärmekammern) größer sein als in den Kühlkammern, insbesondere mindestens um 20K.

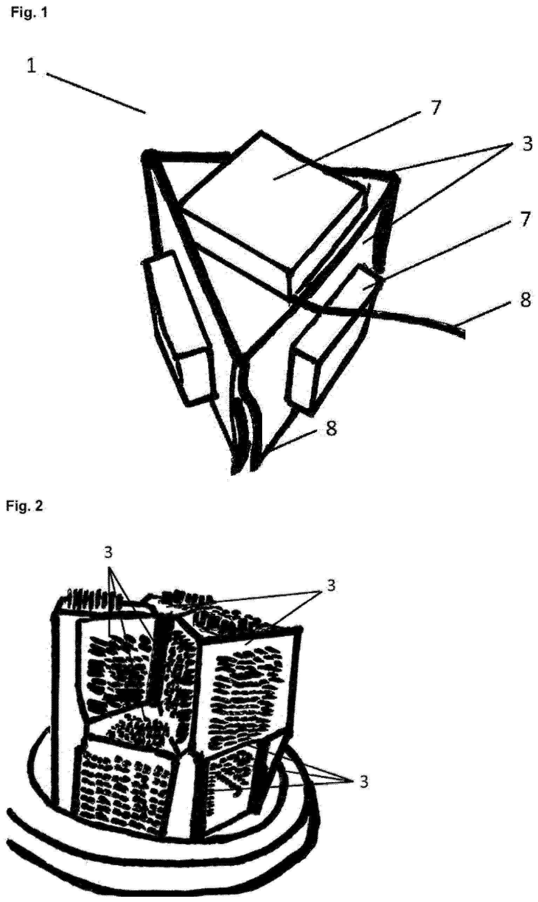

Aufgrund dieses Temperaturunterschieds zwischen Kühl- und Wärmekammern wird an der Wand (oder den Wänden), welche sowohl eine Wärmekammer, als auch eine Kühlkammer begrenzen, mittels des Peltierelements der Wand Strom erzeugt. Es wird erkennbar auch an den Wänden Strom erzeugt, welche Kühlkammer zum Aufheizbereich abgrenzen (so wie beispielsweise bei den in Ausführungsbeispiel 1/Fig. 2 gezeigten, zur Seite nach außen weisenden Wandflächen).

Gegenstand ist des Weiteren auch ein Set zur Umwandlung von Wärmeenergie in elektrischen Strom, umfassend die erfindungsgemäße Vorrichtung, mit einer Batterie, welche an die Peltierelemente angeschlossen ist, und/oder mit einer Linse zum Leiten des Sonnenlichts auf die Vorrichtung. In einer weiter unten genannten bevorzugten Ausführung mit Elektroheizung wäre sinnvoller Weise die Batterie auch an diese Elektroheizung angeschlossen.

Es ist auch Gegenstand der Erfindung: ein Verfahren zur Umwandlung von Wärmeenergie in elektrischen Strom mit den Schritten:
a) Aufheizen des Aufheizbereichs der erfindungsgemäßen Vorrichtung bis zu einer Temperaturdifferenz zwischen Kühlkammern und Wärmekammern von mindestens 20K (die Wärmekammern haben die höhere Temperatur und die Kältekammern die niedrigere), zum Erstladen einer an die Vorrichtung angeschlossenen Batterie, und
b) kontinuierliche Kühlung der abgeschlossenen Kühlkammern mittels eines flüssigen oder gasförmigen Kühlmediums.

Ausführungen für das Verfahren betreffen somit erkennbar auch das erfindungsgemäße Set mit Batterie oder eine Ausführung der Vorrichtung mit Batterie.

Gegenstand ist schließlich auch die Verwendung der erfindungsgemäßen Vorrichtung (bzw. des Sets) zur Integration in eine Wohnraumwand eines Gebäudes, wobei das Kühlmedium für die Kühlkammern zur Abkühlung an der Gebäudebodenplatte vorbeigeführt wird. Denn die Gebäudebodenplatte weist erfahrungsgemäß niedrigere Temperaturen auf als die Umgebungsluft und kann daher der Abkühlung des Kühlmediums dienen, so dass es von dort in die Kühlkammern der erfindungsgemäßen Vorrichtung geleitet werden kann. Insbesondere ist Gegenstand auch die Verwendung im erfindungsgemäßen Verfahren.

Ausführungen für die erfindungsgemäße Vorrichtung betreffen schließlich auch die erfindungsgemäßen Gegenstände Set, Verfahren bzw. Verwendung.

Vorteilhaft erlaubt die Erfindung die mobile Stromgewinnung bei stetiger Kühlung, bspw. mittels eines mobilen Kühlsprays.

Die Vorrichtung kann die Sonne als Start zum Aufheizen des Aufheizbereichs und der dahin offenen Wärmekammern nutzen, um beispielweise eine Batterie zu laden und danach für lange Zeit einen Betrieb auch ohne Sonne zu ermöglichen - notwendig ist lediglich die stetige oder intervallweise Kühlung der Kühlkammern. Der Aufwand zum Erhalt des stetigen und langzeitigen Betriebs ist somit gering.

Durch den Aufbau, bei dem die geschlossene Kühlkammer mit gemeinsamer Wand an eine Wärmekammer angrenzt, mit Isolation durch die Glocke, gelingt es, auch in der Dunkelheit bspw. über Nacht einen Weiterbetrieb zu gewährleisten. Sollte die Sonne auch danach nicht zur Verfügung stehen, ist es möglich, deine Aufheizung auch mittels einer Elektroheizung innerhalb des Aufheizbereichs zu erreichen, wie in einer bevorzugten Ausführung weiter hinten im Dokument beschrieben.

Dieser erfindungsgemäße Aufbau mit "geteilter Wand" erlaubt auch eine mehrstöckige Bauweise.

### Bevorzugte Ausführungsformen

In einer bevorzugten Ausführungsform der Erfindung führt die Leitung für das Kühlmedium von einem Kühlschrank oder Gefrierschrank kommend in die Kühlkammern. Die Vorrichtung umfasst dabei bevorzugt auch eine Batterie (Gleichstrom) und einen 220V-Wechselrichter zum Betrieb eines haushaltsüblichen Wechselstromkühlschranks, wobei diese Batterie an die Peltierelemente der Vorrichtung angeschlossen ist, so dass die Batterie geladen wird.

Bevorzugt ist es im Verfahren, wenn die Wärmekammern (nach dem Aufheizen in Schritt a) eine Temperatur von 50°C ±5°C erreicht und die Temperatur in den Kühlkammern somit bei 30°C ±5°C liegt. Dieser Temperaturbereich hat sich als optimal erwiesen für ein ausgewogenes Gleichgewicht zwischen Energieeintrag (Sonne oder Strom) und Energieaustrag (Kühlung und Energiegewinnung).

Bevorzugt wird beim Verfahren in Schritt b) das Kühlmedium von oben in die jeweiligen Kühlkammern eingeführt. Vorteilhaft ist so die Kühlwirkung entlang der vertikalen Wände und der oberen Wand gleichmäßiger.

Erfindungsgemäß befindet sich im Aufheizbereich der erfindungsgemäßen Vorrichtung ein Wärmesensor und in den Kältekammern jeweils ein Kältesensor. Vorteilhaft kann so der Ziel-Temperaturunterschied von mindestens 20K überwacht werden.

Erfindungsgemäß umfasst die Vorrichtung:
- mindestens drei der Kühlkammern, wobei diese jeweils die Form eines dreiseitigen gleichschenkligen Prismas haben und
   sich einander an ihrer jeweiligen Kante zwischen den gleichen Schenkeln berühren und dort eine Symmetrieachse bilden und
   wobei sie symmetrisch über die 360° um die Symmetrieachse verteilt sind und Zwischenräume bilden (das heißt bei 3 Kühlkammern, sind sie um jeweils 120° versetzt; bei 5 Kühlkammern wären sie um 360°/5 versetzt etc.), und
- mindestens drei der offenen Wärmekammern, welche sich in diesen Zwischenräumen erstrecken, wobei diese offenen Wärmekammern ebenfalls dreiseitige gleichschenklige Prismen sind (d.h. dieser Form haben; wobei, da die Wärmekammern offen sind, von den drei Seitenflächen nur die beiden gleichschenkligen Flächen vorhanden sind - mit Bezug auf die untere Darstellung eines gleichschenkligen Prismas fehlt auf der Fläche c*h sozusagen die Wand),
so dass diese Kühl- und Wärmekammern ein erstes Stockwerk der Vorrichtung bilden, und wobei die Wände (der Kühlkammern) an allen drei Seiten der gleichschenkligen Dreiecke (das sind die Flächen a*h, b*h und c*h in der unteren Darstellung dieser Prismenform) Peltierelemente umfassen und auf beiden Seiten der Wände (Wandseiten) Kühlrippen aufweisen.

Da sich die offenen Wärmekammern in den Zwischenräumen erstrecken sind auch die Wärmekammern über die 360° symmetrisch verteilt, so dass sich in diesem ersten Stockwerk immer eine Kühlkammer und eine Wärmekammer abwechseln). "Erstes Stockwerk" ist das erste von unten gezählt, d.h. vom Boden bzw. einer Bodenplatte aus gesehen.

Die Wärmekammern haben folglich ausschließlich "Wände der Kühlkammern".

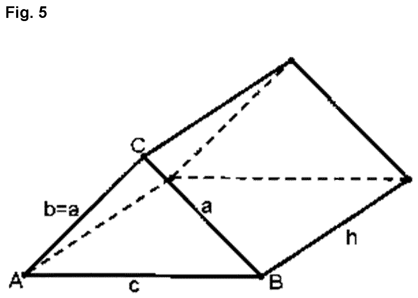

Ein dreiseitiges gleichschenkliges Prisma hat die in Fig. 5 gezeigte geometrische Form:
Die genannte Symmetrieachse ist hierbei die zwischen Punkt C der einen Grundfläche (ABC) und dem Punkt auf der gegenüberliegenden Grundfläche.

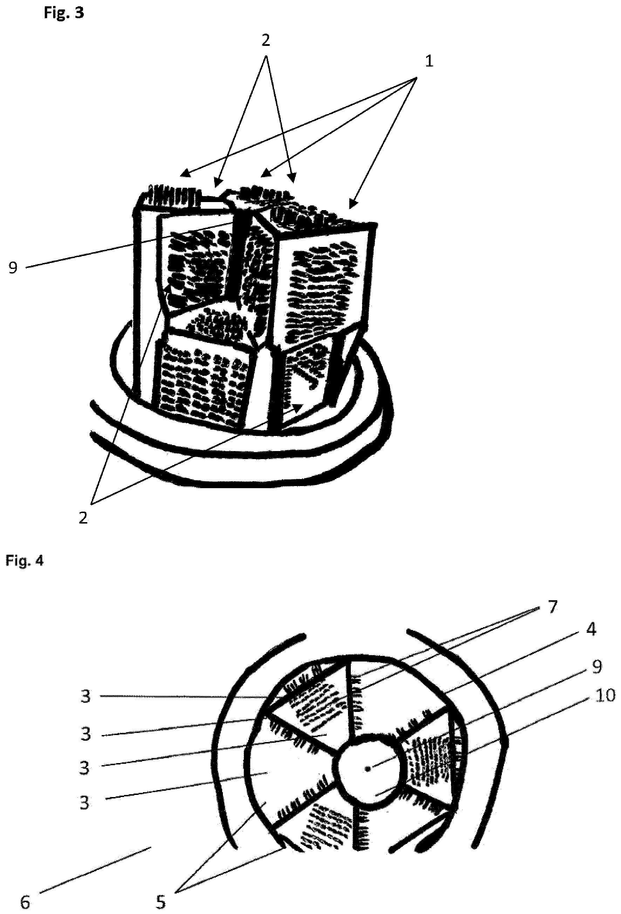

Bevorzugt haben alle Kühlkammern die gleiche Form, folglich haben auch die Wärmekammern die gleiche Form. Hinsichtlich der Wände heißt das (bei einer Ausführung mit genau drei Kühlkammern in einem Stockwerk, wie in Fig. 4), dass in diesem Stockwerk neun (vertikale) Wände existieren, wovon sechs unmittelbar die Kühlkammern und Wärmekammern verbinden und drei die Kühlkammern zum Aufheizbereich abtrennen. Jede dieser Wände umfasst erfindungsgemäß das Peltierelement.

Erkennbar stimmt in dieser (symmetrisch verteilten) Anordnung entlang einer Symmetrieachse die Zahl der Kühlkammern und die Zahl der Wärmekammern im Stockwerk überein.

"Kühlrippen" sind Mittel zur verbesserten Übertragung von Wärmeenergie von oder auf die Peltierelemente der Wände. Die Kühlrippen ragen also auf der einen Seite von einer Kühlkammer weg in den Aufheizbereich und auf der anderen Seite in die Kühlkammer hinein.

Ganz besonders bevorzugt umfassen alle Wände der Kühlkammern Peltierelement mit Kühlrippen auf beiden Seiten der Wand (ausgenommen kann dabei die unterste Wand sein, wenn eine Kühlkammer ohne Abstandshalter unmittelbar auf dem Boden liegt).

In einer besonders bevorzugten Variante dieser Ausführung mit mindestens drei Kühlkammern und mindestens 3 Wärmekammern sind die Seitenwände, die das gleichschenklige Prisma bilden, miteinander verklebt; insbesondere können alle Wände der erfindungsgemäßen Vorrichtung miteinander verklebt sein.

In einer bevorzugten Ausführungsform der Erfindung weisen die Wände zu mindestens 75% ihrer jeweiligen Fläche solche Kühlrippen (auf beiden Seiten der Wand) auf. Auf jeden Fall bedecken die Kühlrippen dabei mindestens die gleiche Fläche der Wand, die durch das Peltierelement gebildet wird.

Erfindungsgemäß ist mindestens ein weiteres Stockwerk im gleichen Aufbau, wie das erste Stockwerk, umfasst und dieses weitere Stockwerk befindet sich über dem ersten Stockwerk, wobei erstes und jedes weitere (nach oben folgende) Stockwerk zueinander so um die Symmetrieachse versetzt sind, dass jede Kühlkammer von oben durch eine Wärmekammer und umgekehrt begrenzt wird.

Das heißt, auch dieses weitere Stockwerk (es sind auch mehr als zwei Stockwerke möglich) umfasst die mindestens drei Kühlkammern und die mindestens drei Wärmekammern etc. Sinnvollerweise bilden dann auch die dreieckige Ober- und Unterseite aller Kältekammern des (oben befindlichen) weiteren Stockwerks erfindungsgemäße Wände mit Peltierelement.

Ein Stockwerk ist jeweils gegenüber dem daran angrenzenden Stockwerk um 360°/(2x) versetzt, wobei x die Anzahl an Kühlkammern im Stockwerk ist. Das heißt bei 3 Kühlkammern pro Stockwerk befinden sich auf einem Stockwerk 3 Kühl- und 3 Wärmekammern, d.h. insgesamt sechs Kammern. Das daran angrenzende Stockwerk ist um 360°/6 versetzt (bzw. genauer: um die Symmetrieachse gedreht), d.h. um 60°. Dadurch befindet sich über einer Kühlkammer eine Wärmekammer und umgekehrt.

Vorteil dieser mehrstöckigen Bauweise ist eine bessere Wirksamkeit und ein längerer Betrieb auch ohne Sonneneinstrahlung bzw. elektrischer Aufheizung.

Das unterste Stockwerk (erstes Stockwerk) wird sinnvollerweise durch eine Grundplatte begrenzt, auf welche die erfindungsgemäße Glocke aufgesetzt werden kann. Wie bereits weiter oben erwähnt, ist es allerdings auch möglich, die Vorrichtung auf Abstandshalter oder Stelzen zu positionieren, so dass auch unterhalb ein Aufheizbereich gebildet wird, der durch die Glocke von der Außenumgebung abgeschirmt wird.

In einer anderen bevorzugten Ausführungsform ist die Wand zu 70% (bevorzugt zu 75-85%) der Fläche aus dem Peltierelement gebildet; insbesondere ist das bei allen Wänden so. Der Rest der Wandfläche kann zur besseren Isolierung mit Aluminiumfolie verkleidet sein. Denn der Wärmetransport durch die Wand soll nur an den Stellen des Peltierelements erfolgen.

In einer ebenfalls bevorzugten Variante der o.a. Ausführungsform der Erfindung mit Symmetrieachse ist im Bereich dieser Symmetrieachse eine Steigleitung vorhanden, in welcher die Leitungen für das flüssige oder gasförmige Kühlmittel angeordnet sind.

Sie führen dort von Stockwerk zu Stockwerk (falls mehrere Stockwerke vorhanden sind); jedenfalls können die Leitungen von dort aus problemlos in alle Kühlkammern geführt werden, da jede Kühlkammer (in dieser Ausführungsform) an ihrer jeweiligen Kante zwischen den gleichen Schenkeln (des gleichschenkligen Prismas) einander berühren.

Die "Steigleitung" ist ein Rohr, in deren Mitte sich die Symmetrieachse befindet und an das jede Kältekammer angrenzt. Vorteilhaft ist diese Anordnung am besten geeignet, um platzsparend die Leitungen für das Kühlmedium und elektrische Kabel zu verstauen, die in die Kühlkammern (bzw. richtiger Weisen an die Peltierelemente) geführt werden müssen.

In einer bevorzugten Ausführungsform der Erfindung sind auf beiden Seiten der Wände Kühlrippen angeordnet. Diese sind bevorzugt aus einem Material, ausgewählt aus Aluminium und Kupfer.

In einer bevorzugten Variante der Ausführung mit mindestens drei Kühlkammern und mindestens drei Wärmekammern erstreckt sich mindestens in einer Wärmekammer des ersten (untersten) Stockwerks eine Elektroheizung zwischen Aufheizbereich und Wärmekammer; besser in jeder Wärmekammer des ersten Stockwerks.

Besonders bevorzugt handelt es sich dabei um eine gerollte Heizfolie.

Vorteil ist, dass diese Elektroheizung sowohl zum erstmaligen Aufheizen (bei geschlossener Glocke), als auch zum späteren Heizen des Aufheizbereichs genutzt werden kann, so dass damit auch ein Einsatz der Vorrichtung bei Dunkelheit möglich ist. Sonnenlicht wird nicht mehr benötigt.

In einer weiteren bevorzugten Ausführungsform der Erfindung ist die Glocke aus Glas oder PVC und zu mindestens 35% Ihrer Fläche mit einer Reflexionsfolie verkleidet (insbesondere 35-50%). Vorteil dieser transparenten Ausführung ist, dass Sonnenlicht hindurchdringen kann und im Innern der Glocke an der Reflexionsfolie reflektiert wird. Dies eignet sich, um den Aufheizbereich der erfindungsgemäßen Vorrichtung in der Sonne aufzuheizen.

Die Folie ist so angeordnet, dass von schräg oben auf die Glocke einfallendes Licht der Sonne hinter den Kühl- und Wärmekammern von der Innenseite der Glocke reflektiert wird, so dass mehr Wärmeenergie der Sonne innerhalb der Glocke im Aufheizbereich zur Verfügung steht.

Es ist ebenfalls bevorzugt, wenn das Peltierelement quadratisch ist und eine Größe von 4cm x 4cm bis 8cm x 8cm aufweist.

In einer bevorzugten Variante der Ausführung mit mindestens drei Kühlkammern und mindestens drei Wärmekammern hat die Vorrichtung genau drei Wärmekammern und drei Kühlkammern pro Stockwerk. Vorteilhaft hat eine Kältekammer dabei warme Außenflächen (bis auf die Kältekammer im untersten Stockwerk). Diese Variante ist besonders geeignet, um platzsparend zu sein bei gleichzeitig gutem Wirkungsgrad und noch einfacher Bauweise. Die Bauweise ist dabei auch nicht zu klein, um noch händisch gefertigt werden zu können.

In einer bevorzugten Ausführungsform des erfindungsgemäßen Verfahrens erfolgt das Aufheizen in Schritt a) mittels
- Einstrahlen von Sonnenstrahlung auf die Vorrichtung, und/oder
- Aufheizen des Aufheizbereichs mittels einer Elektroheizung. Auch beides ist möglich.

Die Elektroheizung ist bestenfalls eine gerollte Heizfolie, wie oben bereits beschrieben.

Vorteil ist, dass das erstmalige Aufheizen der Vorrichtung (bei geschlossener Glocke) nicht durch Sonnenlicht stattfinden muss, sondern auch über die Elektroheizung stattfinden kann.

Die Vorrichtung in dieser Ausführung funktioniert also auch ohne Sonnenlicht.
Fig. 1 zeigt auszugsweise eine Kühlkammer einer bevorzugten Ausführungsform aus Ausführungsbeispiel 1. Jede der gezeigten Wände kann eine Wand einer angrenzenden Wärmekammer bilden.
Fig. 2 zeigt die zweistöckige Ausführung der Vorrichtung nach Ausführungsbeispiel 1 (die Glocke ist nicht gezeigt).
Fig. 3 kennzeichnet in der gleichen Abbildung die Kühlkammern und die Wärmekammern sowie die zentral gelegene Symmetrieachse.
Fig. 4 zeigt die Aufsicht auf diese zweistöckige Ausführung mit Kennzeichnung der Glocke, die den Aufheizbereich (im Innern der erfindungsgemäßen Vorrichtung) von der Außenumgebung abgrenzt und thermisch isoliert. Erkennbar ist das obere Stockwerk mit seinen (vertikal verlaufenden) Wänden sowie die (horizontalen) oberen Wandflächen der Kühlkammern des unteren Stockwerks (welche auch Kühlrippen aufweisen, welche aber nicht gezeigt sind). Es sei angemerkt, dass es einen gemeinsamen Aufheizbereich der Vorrichtung gibt, das heißt die in
Fig. 4 erkennbaren Prismen grenzen an der Glocke 4 nicht an, sondern lassen einen Spalt, so dass im Innern der Glocke ein gemeinsamer Aufheizbereich gebildet wird.
Fig. 5 zeigt ein dreiseitiges gleichschenkliges Prisma.

Nachfolgend soll die Erfindung anhand eines bevorzugten Ausführungsbeispiels eingehender erläutert werden. Es soll dabei die Erfindung nicht beschränken.

### Ausführungsbeispiel 1

Die in den Figuren dargestellte Ausführungsform gemäß Ausführungsbeispiel 1 ist eine zweistöckige Vorrichtung. Die Glocke 4 ist, bis auf Fig. 4, nicht gezeigt und dient dazu, über die Kühl- und Wärmekammern (1,2) gestülpt zu werden, so dass der Aufheizbereich 5 von der Außenumgebung 6 der Vorrichtung abgegrenzt und isoliert wird.

Jedes Stockwerk hat jeweils drei Kühlkammern 1 und drei Wärmekammern 2. Alle sechs sind symmetrisch um eine Symmetrieachse 9 verteilt. Im Bereich der Symmetrieachse 9 befindet sich eine Steigleitung 10, in der die Leitungen 8 für das Kühlmedium und auch sinnvollerweise die elektrischen Kabel, die zu den Peltierelementen führen, verstaut sind. Die symmetrische Anordnung der Kühl- und Wärmekammern des einen Stockwerks ist im anderen Stockwerk um genau 360°/6, das heißt um 60° um die Symmetrieachse versetzt. Jede der vorhandenen Wände (aller Kühl- und aller Wärmekammern) besitzt ein Peltierelement wobei in der Fläche des Peltierelements sowohl innen und außen (also auf beiden Seiten der Wand) Kühlrippen 7 angebracht - ausgenommen sind hier nur die unterste Wand des untersten Stockwerks, welche mit der Botenplatte in Berührung stehen.

Auszugs weise sind die Kühlkammern in Fig. 1 gezeigt. Dort befinden sich die Peltierelemente unterhalb der Kühlrippen 7.

### Bezugszeichen

- 1: Kühlkammern (geschlossen)
- 2: Wärmekammern (zum Aufheizbereich offen)
- 3: Wände, umfassend Peltierelement
- 4: Glocke
- 5: Aufheizbereich
- 6: Außenumgebung (außerhalb der von der Glocke abgeschlossenen Kühl- und Wärmekammern)
- 7: Kühlrippen
- 8: Leitungen (für Kühlmedium mit Zufluss in die Kühlkammern)
- 9: Symmetrieachse
- 10: Steigleitung (für Leitungen für Kühlmedium)

## Patentansprüche

1. Vorrichtung zur Umwandlung von Wärmeenergie in elektrischen Strom, umfassend
• mindestens eine durch Wände (3) abgeschlossene Kühlkammer (1),
• mindestens eine nach außen zu einem Aufheizbereich (5) offene Wärmekammer (2), wobei Wärme- und Kühlkammer mittels einer dieser Wände (3) aneinander angrenzen, so dass diese Wand der Kühlkammer auch eine Wand der Wärmekammer bildet, und wobei diese Wand ein Peltierelement umfasst,
wobei sich im Aufheizbereich ein **Wärmesensor** und in den Kühlkammern jeweils ein **Kältesensor** befindet, und
• Leitungen (8) für ein flüssiges oder gasförmiges Kühlmedium mit einem Zufluss in die Kühlkammern (1), und
• eine Glocke (4), welche alle Kühlkammern (1) und Wärmekammern (2) umgibt und den Aufheizbereich (5) der Vorrichtung von der Außenumgebung (6) abgrenzt,
wobei umfasst sind:
• mindestens **drei der Kühlkammern** (1), wobei diese jeweils die Form eines dreiseitigen gleichschenkligen Prismas haben und
sich einander an ihrer jeweiligen Kante zwischen den gleichen Schenkeln berühren und dort eine Symmetrieachse (9) bilden und
wobei sie symmetrisch über die 360° der Symmetrieachse verteilt sind und Zwischenräume bilden, und
• mindestens **drei der offenen Wärmekammern** (2), welche sich in den Zwischenräumen erstrecken, und wobei diese offenen Wärmekammern ebenfalls dreiseitige gleichschenklige Prismen sind,
so dass diese Kühl- und Wärmekammern ein erstes Stockwerk der Vorrichtung bilden, und
wobei die Wände an allen drei Seiten der gleichschenkligen Dreiecke Peltierelemente umfassen und auf beiden Wandseiten Kühlrippen (7) aufweisen, und
wobei mindestens ein weiteres Stockwerk im gleichen Aufbau, wie das erste Stockwerk, umfasst ist und sich dieses über dem ersten Stockwerk befindet, wobei erstes und jedes weitere Stockwerk zueinander so um die Symmetrieachse (9) versetzt sind, dass jede Kühlkammer (1) von oben durch eine Wärmekammer (2) und umgekehrt begrenzt wird.

2. Vorrichtung nach Anspruch 1, wobei die Wand (3) zu 70% der Fläche aus dem Peltierelement gebildet ist.

3. Vorrichtung nach einem der Ansprüche 1 oder 2, wobei im Bereich der Symmetrieachse (9) eine Steigleitung vorhanden ist, in welcher die Leitungen (8) für das flüssige oder gasförmige Kühlmittel angeordnet sind.

4. Vorrichtung nach einem der Ansprüche 1 bis 3, wobei die Kühlrippen (7) aus einem Material, ausgewählt aus Aluminium und Kupfer, sind.

5. Vorrichtung nach Anspruch 4, wobei sich mindestens in jeder Wärmekammer (2) des untersten Stockwerks eine Elektroheizung zwischen Aufheizbereich (5) und Wärmekammer erstreckt.

6. Vorrichtung nach einem der Ansprüche 1 bis 5, wobei die Glocke (4) aus Glas oder PVC ist, und zu mindestens 35% Ihrer Fläche mit einer Reflexionsfolie verkleidet ist.

7. Vorrichtung nach einem der Ansprüche 1 bis 6, wobei das Peltierelement quadratisch ist in der Größe 4cm x 4cm oder 8cm x 8cm.

8. Vorrichtung nach einem der Ansprüche 1 bis 6 mit drei Wärmekammern (2) und drei Kühlkammern (1) pro Stockwerk.

9. Set zur Umwandlung von Wärmeenergie in elektrischen Strom, umfassend eine Vorrichtung nach einem der Ansprüche 1 bis 8, mit einer Batterie, welche an die Peltierelemente angeschlossen ist, und mit einer Linse zum Leiten des Sonnenlichts auf die Vorrichtung.

10. Verwendung einer Vorrichtung nach einem der Ansprüche 1 bis 8 zur Integration in eine Wohnraumwand eines Gebäudes, wobei das Kühlmedium für die Kühlkammern (1) zur Abkühlung an der Gebäudebodenplatte vorbeigeführt wird.

11. Verfahren zur Umwandlung von Wärmeenergie in elektrischen Strom mit den Schritten:
a) Aufheizen des Aufheizbereichs (5) einer Vorrichtung nach einem der Ansprüche 1 bis 8 bis zu einer Temperaturdifferenz zwischen Kühlkammern (1) und Wärmekammern (2) von mindestens 20K, zum Erstladen einer an die Vorrichtung angeschlossenen Batterie, und
b) kontinuierliche Kühlung der abgeschlossenen Kühlkammern mittels eines flüssigen oder gasförmigen Kühlmediums.

12. Verfahren nach Anspruch 11, wobei das Aufheizen in Schritt a) erfolgt mittels
- Einstrahlen von Sonnenstrahlung auf die Vorrichtung, und/oder
- Aufheizen des Aufheizbereichs mittels einer Elektroheizung.

## Claims

1. Device for converting thermal energy into electric power, comprising
• at least one cold chamber (1) closed by walls (3),
• at least one heat chamber (2) open to the outside towards a heating-up area (5),
wherein the heat and cold chambers adjoin one another by means of one of these walls (3), so that this wall of the cold chamber also forms a wall of the heat chamber, and wherein this wall comprises a Peltier element, and
wherein there is a **heat sensor** in the heating-up area and a **cold sensor** in each of the cold chambers, and
• pipes (8) for a liquid or gaseous cooling medium with an inlet into the cold chambers (1), and
• a bell (4), which surrounds all cold chambers (1) and heat chambers (2) and separates the heating-up area (5) of the device from the external environment (6),
comprising:
• at least **three of the cold chambers** (1), each of which having the shape of a three-sided isosceles prism, and
which touch each other at their respective edge between the same legs there forming an axis of symmetry (9), and
where they are symmetrically distributed over the 360° of the axis of symmetry and form intermediate spaces, and
• at least **three of the open heat chambers** (2), which extend into the intermediate spaces, and wherein these open heat chambers are also three-sided isosceles prisms,
so that these cold and heat chambers form a first floor of the device, and
wherein the walls comprise Peltier elements on all three sides of the isosceles triangles and have cooling fins (7) on both sides of the walls, and
wherein at least one further floor is comprised in the same structure as the first floor and this is located above the first floor, wherein the first and each further floor are offset relative to one another around the axis of symmetry (9) in such a way that each cold chamber (1) is limited from above by a heat chamber (2) and vice versa.

2. Device according to claim 1, wherein 70% of the surface of the wall (3) is formed by the Peltier element.

3. Device according to one of claims 1 or 2, wherein a riser pipe is present in the region of the axis of symmetry (9), in which the pipes (8) for the liquid or gaseous cooling medium are arranged.

4. Device according to one of claims 1 to 3, wherein the cooling fins (7) are made of a material selected from aluminium and copper.

5. Device according to claim 4, wherein at least in each heat chamber (2) of the lowest floor an electric heater extends between the heating-up area (5) and the heat chamber.

6. Device according to one of claims 1 to 5, wherein the bell (4) is made of glass or PVC and at least 35% of its surface is covered with a reflective film.

7. Device according to one of claims 1 to 6, wherein the Peltier element is square in the size 4cm x 4cm or 8cm x 8cm.

8. Device according to one of claims 1 to 6 with three heat chambers (2) and three cold chambers (1) per floor.

9. Set for converting thermal energy into electric power, comprising a device according to one of claims 1 to 8, with a battery connected to the Peltier elements and with a lens for directing sunlight onto the device.

10. Use of a device according to one of claims 1 to 8 for integration into a living space wall of a building, wherein the cooling medium for the cold chambers (1) is guided past the building base plate for cooling.

11. Process for converting thermal energy into electric power with the steps:
a) Heating-up the heating-up area (5) of a device according to one of claims 1 to 8 up to a temperature difference between cold chambers (1) and heat chambers (2) of at least 20K, for initial charging of a battery connected to the device, and
b) Continuous cooling of the closed cold chambers by means of a liquid or gaseous cooling medium.

12. Process according to claim 11, wherein the heating-up in step a) is carried out by means of
- Irradiation of solar radiation onto the device, and/or
- Heating up the heating-up area using an electric heater.

## Revendications

1. Dispositif permettant de convertir l'énergie thermique en courant électrique, comprenant
• au moins une chambre de refroidissement (1) fermée par des parois (3),
• au moins une chambre de chauffage (2) ouverte vers l'extérieur sur une zone de chauffage (5),
dans lequel les chambres de chauffage et de refroidissement sont contiguës l'une à l'autre au moyen de l'une desdites parois (3), de sorte que ladite paroi de la chambre de refroidissement forme également une paroi de la chambre de chauffage, et dans lequel ladite paroi comprend un élément Peltier,
dans lequel un **capteur de chaleur** se trouve dans la zone de chauffage et un **capteur de froid** se trouve respectivement dans les chambres de refroidissement, et
• des conduites (8) pour un milieu de refroidissement liquide ou gazeux, comportant une arrivée dans les chambres de refroidissement (1), et
• une cloche (4) qui entoure toutes les chambres de refroidissement (1) et chambres de chauffage (2) et qui délimite la zone de chauffage (5) du dispositif par rapport à l'environnement extérieur (6),
dans lequel sont comprises :
• au moins **trois des chambres de refroidissement** (1), dans lequel celles-ci possèdent respectivement la forme d'un prisme isocèle à trois faces, et
se touchent les unes les autres au niveau de leur bord respectif entre les côtés identiques et forment à cet endroit un axe de symétrie (9), et
dans lequel elles sont réparties symétriquement sur les 360° de l'axe de symétrie et forment des espaces intermédiaires, et
• au moins **trois des chambres de chauffage ouvertes** (2) qui s'étendent dans les espaces intermédiaires, et dans lequel lesdites chambres de chauffage ouvertes sont elles aussi des prismes isocèles à trois faces,
de sorte que lesdites chambres de refroidissement et de chauffage forment un premier étage du dispositif, et
dans lequel les parois des trois faces des triangles isocèles comprennent des éléments Peltier et présentent des ailettes de refroidissement (7) sur les deux faces de paroi, et
dans lequel au moins un autre étage, de même structure que le premier étage, est compris et se situe au-dessus du premier étage, dans lequel le premier étage et chaque étage supplémentaire sont décalés les uns par rapport aux autres autour de l'axe de symétrie (9) de sorte que chaque chambre de refroidissement (1) est délimitée par le haut par une chambre de chauffage (2), et inversement.

2. Dispositif selon la revendication 1, dans lequel la paroi (3) est formée à 70 % de sa surface par l'élément Peltier.

3. Dispositif selon l'une des revendications 1 ou 2, dans lequel une conduite ascendante est prévue dans la zone de l'axe de symétrie (9), conduite ascendante dans laquelle sont disposées les conduites (8) destinées au milieu de refroidissement liquide ou gazeux.

4. Dispositif selon l'une des revendications 1 à 3, dans lequel les ailettes de refroidissement (7) sont en un matériau choisi parmi l'aluminium et le cuivre.

5. Dispositif selon la revendication 4, dans lequel, au moins dans chaque chambre de chauffage (2) de l'étage le plus bas, un chauffage électrique s'étend entre la zone de chauffage (5) et la chambre de chauffage.

6. Dispositif selon l'une des revendications 1 à 5, dans lequel la cloche (4) est en verre ou en PVC et est recouverte d'un film réfléchissant sur au moins 35 % de sa surface.

7. Dispositif selon l'une des revendications 1 à 6, dans lequel l'élément Peltier est de forme carrée et mesure 4 cm x 4 cm ou 8 cm x 8 cm.

8. Dispositif selon l'une des revendications 1 à 6, comportant trois chambres de chauffage (2) et trois chambres de refroidissement (1) par étage.

9. Ensemble permettant de convertir l'énergie thermique en courant électrique, comprenant un dispositif selon l'une des revendications 1 à 8, comportant une batterie qui est connectée aux éléments Peltier, et comportant une lentille permettant de diriger la lumière solaire vers le dispositif.

10. Utilisation d'un dispositif selon l'une des revendications 1 à 8, pour l'intégration dans un mur de pièce d'habitation d'un bâtiment, dans laquelle le milieu de refroidissement destiné aux chambres de refroidissement (1) rase la dalle de fondation de bâtiment pour permettre le refroidissement.

11. Procédé permettant de convertir l'énergie thermique en courant électrique, comportant les étapes consistant à :
a) chauffer la zone de chauffage (5) d'un dispositif selon l'une des revendications 1 à 8 jusqu'à obtenir une différence de température d'au moins 20 K entre les chambres de refroidissement (1) et les chambres de chauffage (2), pour la première charge d'une batterie connectée au dispositif, et
b) refroidir en continu les chambres de refroidissement fermées au moyen d'un milieu de refroidissement liquide ou gazeux.

12. Procédé selon la revendication 11, dans lequel le chauffage de l'étape a) est effectué au moyen
- de l'exposition du dispositif au rayonnement solaire, et/ou
- du chauffage de la zone de chauffage au moyen d'un chauffage électrique.
